# EUROPEAN PATENT SPECIFICATION

(11) **EP 1 731 961 B1**
(45) Date of publication and mention of the grant of the patent: **05.11.2008**
(21) Application number: 05105100.1
(22) Date of filing: 10.06.2005
(51) Int. Cl.: G03F 7/00

(54) **Template replication method**
Verfahren zum Kopieren eines Modells
Méthode pour la reproduction d'un modèle

(43) Date of publication of application: 13.12.2006
(73) Proprietor: Obducat AB, 201 25 Malmö (SE)
(72) Inventor: Heidari, Babak, 244 65 Furulund (SE); Bolmsjö, Erik, 217 51 Malmö (SE); Beck, Marc, 245 95 Höör (SE)
(74) Representative: Lindberg, Olle Nils Olof

(56) References cited:
- EP-A- 0 813 255
- WO-A-97/06468
- DE-A1- 3 714 011
- GB-A- 559 072
- JP-A- 2002 086 463
- US-A1- 2003 017 424
- US-A1- 2003 071 016

## Description

### Field of Invention

The present invention relates to a pattern transfer process in which a replica of a template having a patterned surface is formed into a flexible polymer foil whereas the template surface is placed in contact to the foil leading to an inverted pattern transfer from the template to the polymer surface after deforming the surface of the polymer foil. The so-produced flexible polymer replica having the inverted or negative surface pattern to that of the original template can optionally be used as a new template to produce a second replica into another flexible polymer foil, in a similar process as described above. The so-produced flexible positive (the pattern is similar to that of the original template) or negative (the pattern is inverted to that of the original template) polymer replicas will be used as polymer templates in a subsequent imprint process, in which one of the flexible polymer templates is placed in contact with a surface of an object comprising a substrate covered by a thin polymer film. By deforming the surface of the polymer film the pattern is transferred from one of the flexible polymer templates into the object surface. Through a subsequently performed process the pattern can furthermore be transferred from the polymer film into the substrate material. More particularly, the invention relates to a process method for reproducing a pattern from a template in order to manufacture replicas from this template into different materials through a subsequent development process.

### Background

One of the most powerful techniques for reproducing nanostructures - i.e. structures in the order of 100 nm or smaller ― is nano-imprint lithography (NIL). In nano-imprint lithography an inverted copy of the surface pattern of a template - often called as a stamp - is transferred into an object, comprising a substrate and, applied thereto, a film of e.g. a polymer material, often called resist. After heating the object to a suitable temperature above the glass transition temperature of the polymer film the stamp is pressed towards the film followed by cooling and release - often called as demolding - of the stamp after the desired pattern depth has been transferred into the film. Alternatively, if the substrate is covered by a photo-resist material ― a polymer which is cross-linkable upon exposure to radiation - the polymer film can be cured after applied exposure to radiation when either the substrate or the stamp material is due to its optical properties transparent to the applied radiation. In a subsequently performed process after the achieved imprint the object - comprising the substrate and a patterned surface film - can be post-processed e.g. by etching of the substrate within the imprinted regions.

The imprint process described above exhibits some difficulties, which have to be considered in order to achieve a perfect pattern transfer from the template - or stamp - into the polymer film covering the substrate:
1) Different thermal expansion coefficients of the stamp and substrate material can lead to complications to transfer the inverted pattern from the stamp to the polymer film covering the substrate in a suitable way, leading to a reduced replication fidelity.
2) Inflexible stamp or substrate material can lead to the inclusion of air between stamp and polymer film when the stamp is pressed towards the substrate, also downgrading the replication fidelity.
3) The inclusion of particles between stamp and polymer during an imprint process can lead to pronounced damages of either the stamp or the substrate especially when neither the stamp nor the substrate are composed by a flexible material.
4) When a polymer, cross-linkable after exposure to radiation, is used during the process either the stamp or the substrate material must be transparent to the applied radiation.
5) The surfaces of the stamp and that of the polymer film must exhibit sufficient anti-adhesion properties in order to release the stamp from the polymer film after performed imprint without damaging the imprinted pattern.
6) For some applications the pattern of the stamp should be reproduced 1:1 into a replica making a two step imprint process desirable where an inverted pattern of the stamp is first transferred into a polymer sheet followed by a second imprint, in which the inverted pattern of the imprint is used as a new stamp to reproduce the pattern of the original stamp into a second polymer film. The material properties of the different polymer materials - e.g. glass transition temperatures, optical transparencies, thermal expansion coefficients, viscosities, and curabilities after exposure to radiation - must be adapted to the two-step process.
7) A once damaged stamp is usually not recyclable.
8) Demolding of inflexible stamp from inflexible substrate material can cause physical damage on both stamp and substrate.
9) It is difficult to demold a substrate and a template including patterns with high aspect ratio after an imprint process.

US 2003/071016 discloses a technique for patterned structure reproduction, in which a disk of non-stick material, e.g. a polymer, is heated above the melting point of the non-stick material and pressed against a master mold, and subsequently cooled, to form a non-stick mold. The non-stick mold is then used as an imprint lithography tool to imprint images onto a flowable composition on a substrate, which is then cured by exposure to UV light or application of heat followed by cooling.

US 2003/017424 discloses a technique for fabricating complex grating structures, in which a flexible imprint master is formed with a pattern by e-beam, optical or other lithography methods. The imprint master is pressed against a molding layer on a substrate, whereupon the molding layer is cured by either thermal treatment or UV radiation.

JP 2002 086463 discloses a method for producing a lens sheet, in which an intermediate die is produced from a cutting die and used to produce a molding die. The intermediate die is produced by applying and pressurizing a silicon resin on the cutting die. The molding die is produced by applying a thermosetting resin to the intermediate die. The lens sheet is produced by applying a radiation-hardening resin to the molding die, together with an overlying resin plate, which are pressed together and exposed to radiation through the resin plate.

The prior art also comprises EP-A-0 813 255, DE 37 14 011, GB 559 072 and WO 97/06468.

### Summary of the invention

It is an object of the invention to provide a solution for an improved imprint process, having high replication fidelity, and which easy and suitable to employ industrially.

In accordance with the invention, a two-step imprint process is provided, which fulfils the mentioned object and overcomes the restrictions described above. In a first step of this two-step process, replicas of a stamp having a patterned surface are formed into flexible polymer foils. In a second step the replicas can be used as flexible polymer templates to reproduce the pattern into an object surface through a subsequent imprint process. The invention is defined in the appended claims.

### Brief description of the drawings

Embodiments of the invention will be described in more detail below, with reference to the accompanying drawings, on which:

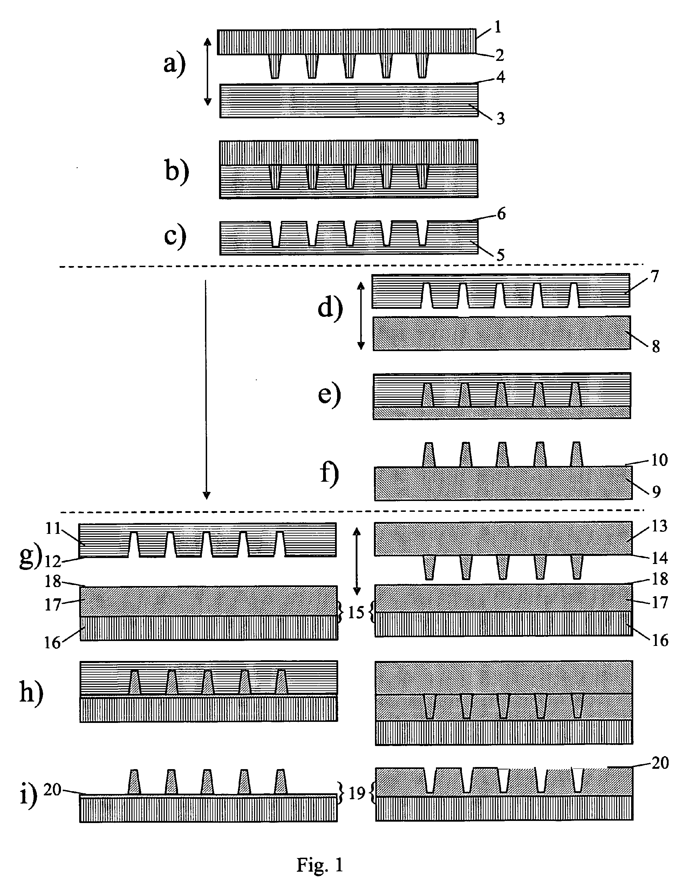

Fig. 1 shows a schematic illustration of the detailed "two-step" process to manufacture replicas from a template into an object surface comprising a substrate covered by a polymer film.

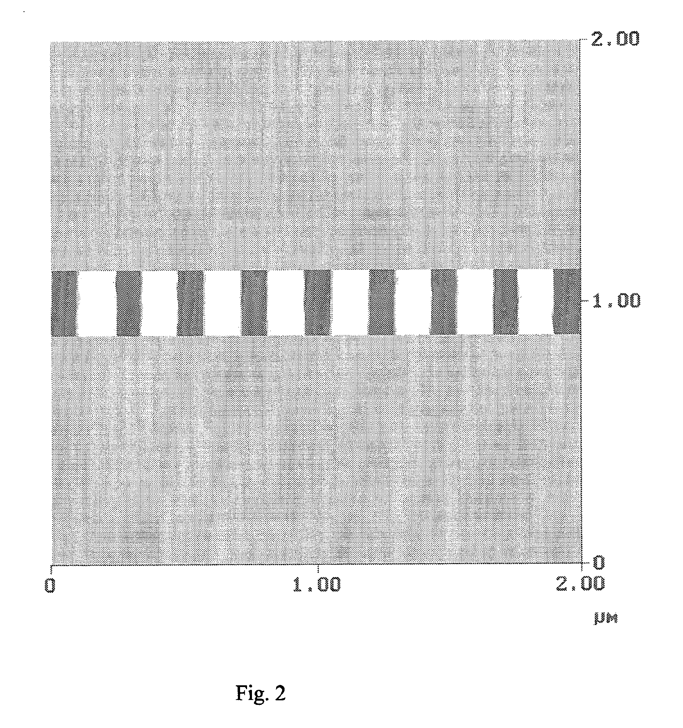

Fig. 2 shows an AFM tapping mode image of a line pattern, imprinted in SU8. First the pattern has been transferred from a Ni template into a Zeonor ZF 14 foil; afterwards the imprinted pattern in Zeonor ZF 14 has been transferred into SU8 film spin-coated on a silicon surface.

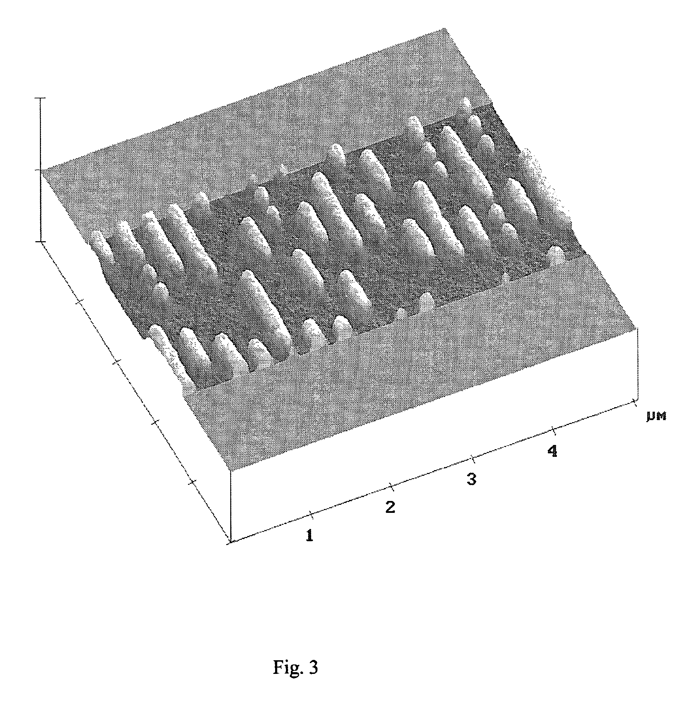

Fig. 3 shows an AFM tapping mode image of a BluRay optical disk pattern, imprinted in SU8. First the pattern has been transferred from a Ni template is into Zeonor ZF 14 foil; afterwards the imprinted pattern in Zeonor ZF 14 has been transferred into SU8 film spin-coated onto a silicon surface employing a combined UV-thermal imprint process.

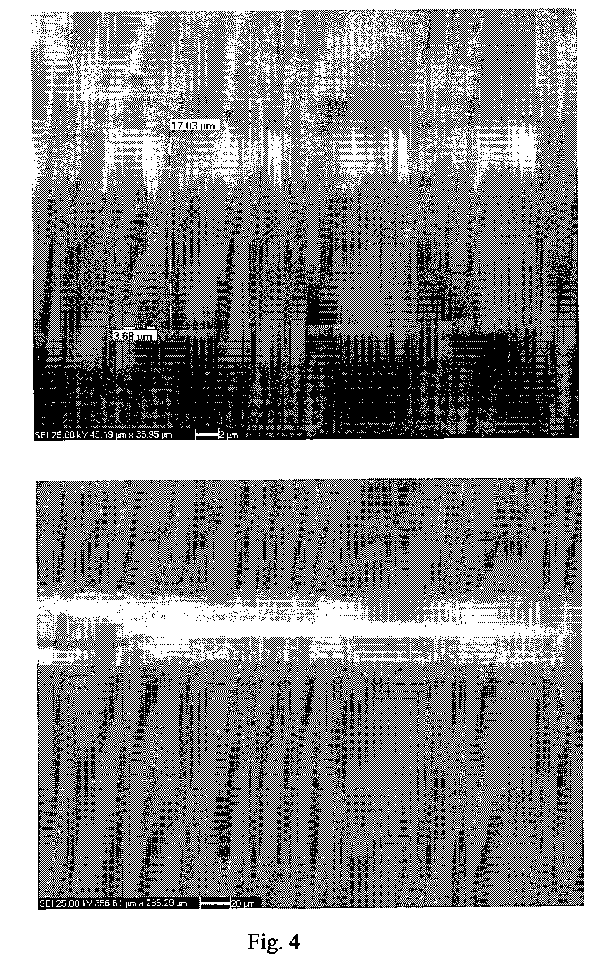

Fig. 4 shows SEM images of a pillar pattern having micro-meter dimensions with high aspect-ratios. First the pattern has been transferred from a Ni template into a polycarbonate foil; afterwards the imprinted pattern in polycarbonate has been transferred into a Topas 8007 foil which was imprinted into a SU8 film spin-coated on a silicon surface employing a combined UV-thermal imprint process. After the imprint the sacrificial Topas stamp was dissolved in Xylene thereby revealing a non-damaged high aspect ratio imprint pattern in SU8, which is hardly accessible via ordinary imprint methods.

### Definitions

The term "nano-imprinting process" or "imprint process" as used herein refers to a process for the creation of an inverted copy of a nano- and/or micro-structured surface pattern of a stamp, which is generated by pressing the stamp into a polymer in order to deform the polymer. The polymer may either be heated-up above its glass transition temperature followed by cooling-down to below said glass transition temperature during the imprinting (e.g., hot embossing) process, and/ or the polymer may be cured with the help of UV-light exposure during or after the imprinting process.

The term "nano-imprint lithography" or "imprint lithography" as used herein refers to the entire process for the replication of a nano- and/or micro-structured surface pattern. The process includes both the production of the stamp provided with or without an anti-adhesion layer, the imprint, and the post-processing, for example the transfer of the imprinted pattern by etching, metallization and lift-off.

The term "two-step imprint process" refers to a process in which in a first step one or more replicas of a stamp or template having a nano- and/ or micro-patterned surface is formed into one or more flexible polymer foils by a performed imprint process. Thereby the patterned surfaces of the created polymer replicas can be transferred into other polymer replicas by a performed imprint process to generate both flexible positive (the pattern is similar to that of the original template) or negative (the pattern is inverted to that of the original template) polymer replicas. In a second step the so-produced replicas can be used as flexible polymer templates to reproduce the pattern into an object surface through a subsequent performed imprint process employing thermal imprint, UV-imprint, or both.

The term "nano-structured master", "stamp" or "template" refers to any patterned material suitable for effecting the transfer of the pattern by the mentioned nano-imprinting or imprint process.

The term "flexible polymer foil" refers to a flexible and ductile in the most cases transparent foil comprising a thermoplast polymer, a thermosetting polymer, and/ or a polymer, cross-linkable after exposure to radiation.

The term "flexible polymer template" refers to a flexible and ductile in the most cases transparent polymer foil having a nano- and/or micro structured surface pattern. The polymer foil comprises a thermoplast polymer, a thermosetting polymer, and/ or a polymer, cross-linkable after exposure to radiation.

The term "replication fidelity" refers to the creation of an inverted copy of the stamp structure in which the inverted topography of the stamp surface is completely reproduced.

### Detailed description of preferred embodiments

The detailed process according to two different embodiments are schematically illustrated in Figure 1.

Figure 1a displays a template 1, composed of e.g. silicon, nickel or other metal such as aluminium, quartz or a polymer material, having a patterned surface 2 usable for transferring a pattern into a flexible polymer foil 3, comprising a thermoplast polymer, a thermosetting polymer, and/ or a polymer, which is cross-linkable with the help of exposure to radiation. The surface 2 of the template 1 and surface 4 of the polymer foil 3 exhibit, due to their material compositions, anti-adhesion properties against to each other. With the help of a suitable imprint process (figure 1 b) the inverted pattern of the template surface 2 is formed into the surface 4 of the flexible polymer foil 3 with the help of an applied pressure pressing the a template 1 and polymer foil 3 together, and of an applied exposure of selected portions of the polymer foil to radiation, after the template surface 2 is placed in contact to that of the polymer surface 4 and after the polymer foil is heated to a temperature above the glass temperature of the used polymer. However, when within the process the material of the polymer foil should be cross-linked after exposure to radiation either the material of the template 1 or that of the polymer foil 3 must be transparent to the applied radiation.

The template 1 and the imprinted polymer foil 5 can be separated either after cooling or without cooling of the polymer foil during or after the performed imprint process depending on the chosen material and its properties. After release of the template from the polymer surface, the imprinted polymer foil 5, also called the replica 5, displayed in figure 1c having the inverted or negative surface pattern 6 to that of the original template 1 can be used as a new flexible template 7 to produce a second inversed replica 9 into another flexible polymer foil 8 in a similar process as described above (see figures 1d - 1f). The polymer foil 8 should be composed by a polymer, whose glass transition temperature and imprint temperature is lower than that of the flexible polymer template 7. Furthermore, the surfaces of both the polymer foil 8 and the flexible polymer template 7 exhibit due to their material compositions anti-adhesion properties against to each other. Anti-adhesion properties could be present from the beginning due to the chemical nature of the used polymer foils and/ or implemented by the deposition of anti-adhesion layers comprising suitable release agents on one or both polymer surfaces. Additionally, if the polymer foil 8 should be cross-linked after exposure to radiation at least one of the polymer foils 7 and 8 must be transparent to the applied radiation or alternatively transmit enough radiation to enable a cross-linking of 8. After performed imprint displayed as in figure 1e the flexible polymer template 7 can be removed from the polymer foil 9 mechanically, i.e. mostly after cooling the polymer foil 9 or - alternatively - the whole template 7 or portions of it can be dissolved chemically with the help of one or more suitable solvents in a suitable process.

The so-produced replicas 5 and 9 having inverted and identical surface patterns to that of the original template 1, respectively, will be used as flexible polymer templates 11 or 13 for an imprint process as displayed in figure 1g ― figure 1i. Here, surfaces 12 or 14 of one of the flexible polymer templates 11 or 13 will be placed in contact to a surface 18 of an object 15 comprising a substrate 16 covered by a thin polymer film 17 comprising a thermoplast polymer, a thermosetting polymer, and/ or a polymer, cross-linkable e.g. with the help of the exposure to UV-light. The surfaces 12 or 14 of the flexible polymer templates 11 or 13 exhibit anti-adhesion properties against the surface 18 of the polymer film 17, due to the material compositions of the surfaces. With the help of an applied pressure forcing one of the flexible polymer templates 11 or 13 and the object 15 together, and optionally an applied exposure of selected portions of the polymer film 17 to radiation, the inverted pattern of the respective polymer template surfaces 12 or 14 is formed into one of the surfaces 18 of one of the polymer films 17 after the substrate is heated to a temperature above the glass temperature of the coated polymer films, as shown in figure 1h. The flexible polymer templates 11 or 13 must be transparent to the applied radiation or show minor absorbance in order to transmit a sufficient amount of radiation necessary for curing the film 17 if the polymer material 17 should be cross-linked after exposure to radiation. After performed imprint as displayed in figure 1h the flexible polymer templates 11 or 13 can be removed from the polymer foil 15 mechanically, i.e. mostly after cooling the polymer templates 11 or 13 or - alternatively - the whole polymer templates 11 or 13, or portions of it, can be dissolved chemically with the help of one or more suitable solvents in a suitable process. As displayed in figure 1i after release of the flexible polymer templates 11 and 13 from the respective object 15 replicas 19 have been produced, exhibiting surfaces having the inverted or negative surface pattern 20 to that of the flexible polymer templates 11 or 13.

Advantages of the application of flexible polymer foils within a "two-step" imprint process as described above and displayed in figure 1 are the following:
a) The flexible properties of the used polymer foils alleviate complications of the pattern transfer due to different thermal expansion coefficients of the applied stamp and substrate materials used in the imprint-process. Therefore, the technique offers possibilities to transfer patterns between surfaces of materials characterized by different thermal expansion coefficients. Nevertheless, most polymers used in the application are characterized by quite similar thermal expansion factors typically ranging between 60 and 70 ×10⁻⁶ C⁻¹ making imprints between two different polymer foils as displayed in figure 1e more easy in terms of manufacturing.
b) The flexible and ductile properties of the used polymer foils prevent the inclusion of air during the imprint between the polymer foil - having either a patterned or non-patterned surface ― and the other object ― e.g. a substrate covered by a polymer film or a template, comprising silicon, nickel, quartz or a polymer material. If the foil is pressed towards one of these objects as displayed in figure 1b, 1e, 1h the polymer foil is acting like a membrane, pressing the air from the centre of the imprinted area to its edges where it can leave the imprinted region.
c) Due to the softness of the used polymer foils particles between the polymer foil and one of the objects -defined in point b)- as well as pronounced surface roughness of one of the objects, evident damages during an imprint process displayed in figure 1b, 1e and 1h of either the polymer foil or of one of the involved objects will be prevented.
d) Due to the high transparency of the used polymer foils to e.g. UV-radiation, also UV-curable polymers can be used during the imprint process described above.
e) The very low surface energies of the most of the applied polymer foils lead to pronounced anti-adhesion properties against other materials, making it ideal to apply them in an imprint process. The deposition of additional anti-adhesion layers on low surface energy polymers is in the most cases not necessary making the process described above simple and industrially applicable. Clearly spoken, it is possible to make the polymer replica stamp in an anti-adhesive material.
f) The process described above and displayed in figure 1 is very suitable to produce both positive (the pattern is similar to that of the original template) and negative (the pattern is inverted to that of the original template) replicas if the material properties of the different polymer materials - e.g. glass transition temperature, optical transparency, and curability after exposure to radiation - applied in the process are adapted to each other.
g) The aging and wear resistance of the used flexible polymer templates 11 and 13 in figure 1g make it possible to apply them several times in the imprint processes shown in figure 1h). This fact enhances the lifetime of the original template 1 in figure 1a.
h) The flexible and ductile properties of the used polymer foils alleviate demolding of the inflexible stamp or substrate from the flexible foil reducing physical damages on the stamp or the substrate.
i) Instead of mechanical demolding of the polymer foil from a substrate after performed imprint, the polymer foil can alternatively be chemically dissolved with the help of a suitable solvent. This procedure would be preferred in case of a transfer of patterns having high aspect ratios, were mechanical demolding could damage the substrate.
j) Not only the pattern on the surface of an original template but also the physical dimension of the original template can easily be transferred into a polymer foil. In some applications the placement of the pattern on the final substrate is critical. For e.g. hard disk drives the pattern should be replicated and aligned to the centre of the disk. Here, the master stamp can be produced with a centre hole. After imprint a relief of the centre hole is formed into the flexible polymer foil, which can be used for aligning the pattern on the foil to the final replicated disk.
k) A replica generated in a polymer sheet can give access to a novel family development process, which is not executable the common way by nickel-to-nickel plating. Here, the imprinted polymer sheet is first bonded together with a rigid substrate by, e.g., a UV-assisted imprint process. Thereafter the sheet is metallized with a seed layer and electroplated to receive a nickel copy of the original. Many other conversion process are accessible via the described invention.

### Examples

Some polymer foils which have been used are:
Topas 8007 from Ticona GmBH, Germany: thermoplastic random co-polymer having a glass temperature of 80°C. Topas is transparent to light with wavelengths above 300 nm and is characterized by a low surface energy. The foil is available in thicknesses of 50 - 500 µm. 130 -140 µm thick foils have been used here.
Zeonor ZF 14 from Zeon Chemicals, Japan: thermoplastic polymer having a glass temperature of 136°C and a light transmittance of 92% for wavelengths above 300 nm. The used foil has a thickness of 188 µm but is available in other thicknesses ranging from 50 to 500 µm.
Zeonex E48R from Zeon Chemicals, Japan: thermoplastic polymer having a glass temperature of 139°C and a light transmittance of 92% for wavelength above 350 nm. The used foil has a thickness of 75 µm.
Polycarbonate (Bisphenol-A polycarbonate) from Bayer AG, Germany: thermoplastic polymer having a glass temperature of 150°C and a light transmittance of 91% for wavelength above 350 nm. The used foil has a thickness of 300 µm and is available in many other thicknesses up to 1 mm.

A resist material which has been used is SU8 from MicroChem Corp. USA, a photo-resist material, curable after exposure to light having wavelengths between 350 and 400 nm. As an adhesion promoter between the SU8 film and the silicon substrate a thin LOR0.7 film from MicroChem Corp. USA has been used.

### Example 1:

A nickel template whose surface exhibits a line pattern, having a line width of 80 nm and a height of 90 nm has been imprinted into a Zeonor ZF 14 foil at 150°C and 50 bar for 3 min. None of the surfaces has been treated by any additional coating such as, e.g. anti-adhesion layers. The release temperature was 135°C, at which the Zeonor foil could mechanically be removed from the nickel surface without damaging the pattern of neither the template nor the replica. The Zeonor foil has been used as a new template, which has been imprinted into a 100 nm thick SU8 film. The SU8 film was spin-coated onto a 20nm LOR film, previously spin-coated onto a silicon substrate. Also here, none of the surfaces has been treated by an additional coating, having the purpose to improve the anti-adhesion behaviour between the SU8 film and the Zeonor foil. The imprint was performed at 70°C and 50 bar for 3 min. The SU8 film was exposed to UV-light for 4 seconds through the optically transparent Zeonor foil and baked for two more minutes. Both temperature and pressure were kept constant at 70°C and 50 bar, respectively, during the entire imprint sequence. The release temperature was 70°C at which the Zeonor foil could mechanically be removed from the SU8 film without damaging the pattern of neither the polymer template foil nor the replica film. The AFM image of an imprint result in the SU8 film deposited on a silicon wafer is shown in figure 2.

### Example2:

A nickel template whose surface exhibits a BluRay pattern having structure heights of 100 nm and widths of 150 nm ― investigated by AFM - has been imprinted into a Zeonor ZF 14 using the same process and the same parameters as already described in Example 1. The Zeonor foil has been used as a new template, which has been imprinted into a 100 nm thick SU8 film. Also here the same process and the same parameters as already described in Example 1 have been used. The AFM image of an imprint result in the SU8 film deposited on a silicon wafer is shown in figure 3.

### Example3:

A nickel template has been used whose surface contains micro-meter patterns with high aspect-ratios ranging from 1-28. The feature size ranges from 600 nm to 12 µm, at a height of 17 µm. The surface has been covered by a phosphate-based anti-adhesion film before the imprint. The nickel template has been imprinted into a polycarbonate foil at 190°C and 50 bar for 3 min. The surface of the polycarbonate foil has not been treated by an additional coating, having the purpose to improve the anti-adhesion behaviour between the Ni template and the polycarbonate film. The release temperature was 130°C, at which the polycarbonate foil could mechanically be removed from the nickel surface without damaging the pattern of neither the template nor the replica. The polycarbonate foil has been used as a new template for an imprint into a Topas foil. The imprint has been performed at 120° C and 50 bar for 3 min. None of the surfaces has been disposed by an additional coating, having the purpose to improve the anti-adhesion behaviour between the polycarbonate and the Topas foil. The release temperature was 70°C, at which the Topas could mechanically be removed from the polycarbonate foil without damaging the pattern of neither the template foil nor the replica foil. The Topas foil has then been used as a new template, which has been imprinted into a 6000 nm thick SU8 film spin-coated onto a silicon substrate. Also here, none of the surfaces has been treated by any additional coating, having the purpose to improve the anti-adhesion behaviour between the SU8 film and the Topas foil. The imprint was performed at 70°C and 50 bar for 3 min. The SU8 film was exposed to UV-light for 4 seconds through the optically transparent Topas foil and baked for two more minutes without changing the temperature of 70°C, or the pressure of 50 bar during the entire process. The release temperature was 70°C. Afterwards the Topas foil has completely been dissolved in a xylene solution at 60° C for one hour. An SEM image of the result is shown in figure 4.

### Experimental:

The Imprint processes have been performed with differently patterned Ni stamps, in some cases covered by phosphate-based anti-adhesion films, using different process parameters. The substrates (2 to 6 inch silicon wafers) have been cleaned by rinsing with isopropanol and acetone directly before spinning the LOR and the SU8 films. The sizes of the applied stamps are 2 to 6 inches. The imprints have been carried out using an Obducat-6-inch-NIL equipment, provided with an UV-module.

Atomic force microscopy (AFM) in the tapping mode with the help of a NanoScope IIIa microscope from Digital Instruments was carried out to investigate both the imprint results and the stamps after performed imprint.

Scanning Electron Microscopy (SEM) has been performed using a Obducat CamScan MX2600 Microscope at 25 kV.

## Claims

1. Method for transferring a pattern from a template to an object in an imprint process, comprising the steps or:
- providing a first polymer foil (3) comprising a polymer which is cross-linkable by exposure to radiation;
- heating the first polymer foil (3) to a first temperature exceeding the glass transition temperature of the material of the first polymer foil (3);
- pressing a pattern of a template surface (2) into a first surface (4) of the first polymer foil (3) to imprint an inverse of the pattern in the first surface (4);
- exposing the first polymer foil (3) to radiation upon pressing the template surface (2) into the first surface (4), to cross-link said polymer;
- releasing the first polymer foil (3) from the template (1); and
- pressing the inverse pattern (6) of the first surface (4) into a second surface of an object (8; 15), to imprint a replica of the pattern of the template surface (2) in the second surface.

2. The method as recited in claim 1, wherein the object is a substrate (16), and the second surface is a resist material layer (17) carried on the substrate (16).

3. The method as recited in claim 1, wherein the object is a second polymer foil (8).

4. The method as recited in claim 3, comprising the steps of:
- releasing the second polymer foil (8) from the first polymer foil (3); and
- pressing the replica of the pattern of the template surface (2) of the second surface into a third surface (18) of a resist material layer (17) carried on a substrate (16), to imprint an inverse of the pattern of the template surface (2) in the third surface (18).

5. The method as recited in claim 3, wherein the second polymer foil (8) is made from a thermoplastic polymer or co-polymer material.

6. The method as recited in claim 1, wherein the first polymer foil (3) is transparent to UV radiation in at least a sub-range within 300-400 nm, and the second surface is the surface of a photo-resist material which is curable upon exposure within at least said sub-range, comprising the step of:
- exposing said photo-resist material of the object to UV radiation, through the first polymer foil (3), upon pressing the inverse pattern (6) of the first surface (4) into the second surface, to cure the photo-resist material.

7. The method as recited in claim 4, wherein the second polymer foil (8) is transparent to UV radiation in at least a sub-range within 300-400 nm, and the third surface (18) is the surface of a photo-resist material which is curable upon exposure within at least said sub-range, comprising the step of:
- exposing said photo-resist material to UV radiation, through the second polymer foil (8), upon pressing the replica (9) of the pattern of the template surface (2) of the second surface into the third surface (18), to cure the photo-resist material.

8. The method as recited in any of the preceding claims, wherein the template (1) is made from metal, quartz, or silicon.

9. The method as recited in any of the preceding claims, comprising the step of:
- heating the object (8; 15), upon pressing the inverse pattern (6) of the first surface (4) into the second surface, to a second temperature which does not exceed said glass transition temperature.

10. The method as recited in claim 9 in conjunction with claim 3, wherein the material of the second polymer foil (8) has a glass transition temperature which is lower than said second temperature.

11. The method as recited in claim 10, wherein the second polymer foil (8) comprises a polymer which is cross-linkable by exposure to radiation, further comprising the step of:
- exposing the second polymer foil (8) to radiation upon pressing the inverse pattern (6) of the first surface (4) into the second polymer foil (8), to cross-link said polymer.

12. The method as recited in any of the preceding claims, wherein the first polymer foil (3) as a thickness of 50 µm to 1 mm.

## Patentansprüche

1. Verfahren zum Übertragen eines Musters von einem Modell aus auf ein Objekt in einem Prägeprozess, mit den Schritten:
- Bereitstellen einer ersten Polymerfolie (3), die ein Polymer aufweist, das durch Bestrahlung vernetzbar ist;
- Erwärmen der ersten Polymerfolie (3) auf eine erste Temperatur, die höher ist als die Glasübergangstemperatur des Materials der ersten Polymerfolie (3);
- Pressen eines Musters einer Modelloberfläche (2) in eine erste Oberfläche (4) der ersten Polymerfolie (3), um in der ersten Oberfläche (4) ein Negativ des Musters zu prägen;
- Bestrahlen der ersten Polymerfolie (3) beim Pressen der Modelloberfläche (2) in die erste Oberfläche (4), um das Polymer zu vernetzen;
- Lösen der ersten Polymerfolie (3) von dem Modell (1); und
- Pressen des Negativmusters (6) der ersten Oberfläche (4) in eine zweite Oberfläche eines Objekts (8;15), um in der zweiten Oberfläche eine Kopie des Musters der Modelloberfläche (2) zu prägen.

2. Verfahren nach Anspruch 1, wobei das Objekt ein Substrat (16) ist und die zweite Oberfläche eine auf dem Substrat (16) getragene Resistmaterialschicht (17) ist.

3. Verfahren nach Anspruch 1, wobei das Objekt eine zweite Polymerfolie (8) ist.

4. Verfahren nach Anspruch 3, mit den Schritten:
- Lösen der zweiten Polymerfolie (8) von der ersten Polymerfolie (3) ; und
- Pressen der Kopie des Musters der Modelloberfläche (2) der zweiten Oberfläche in eine dritte Oberfläche (18) einer auf einem Substrat (16) getragenen Resistmaterialschicht (17), um in der dritten Oberfläche ein Negativ des Musters der Modelloberfläche (2) zu prägen.

5. Verfahren nach Anspruch 3, wobei die zweite Polymerfolie (8) aus einem thermoplastischen Polymer- oder Copolymermaterial hergestellt ist.

6. Verfahren nach Anspruch 1, wobei die erste Polymerfolie (3) für UV-Strahlung durchlässig ist, zumindest in einem Teilbereich von 300-400nm, und die zweite Oberfläche die Oberfläche eines Photoresistmaterials ist, das aushärtbar ist, zumindest bei einer Belichtung in dem Teilbereich, mit dem Schritt:
- Bestrahlen des Photoresistmaterials des Objekts mit UV-Strahlung durch die erste Polymerfolie (3) hindurch beim Pressen des Negativmusters (6) der ersten Oberfläche (4) in die zweite Oberfläche, um das Photoresistmaterial auszuhärten.

7. Verfahren nach Anspruch 4, wobei die zweite Polymerfolie (8) für UV-Strahlung durchlässig ist, zumindest in einem Teilbereich von 300-400nm, und die dritte Oberfläche (18) die Oberfläche eines Photoresistmaterials ist, das aushärtbar ist, zumindest bei einer Belichtung in dem Teilbereich, mit dem Schritt:
- Bestrahlen des Photoresistmaterials mit UV-Strahlung durch die zweite Polymerfolie (8) hindurch beim Pressen der Kopie (9) des Musters der Modelloberfläche (2) der zweiten Oberfläche in die dritte Oberfläche (18), um das Photoresistmaterial auszuhärten.

8. Verfahren nach einem der vorstehenden Ansprüche, wobei das Modell (1) aus Metall, Quarz oder Silizium hergestellt ist.

9. Verfahren nach einem der vorstehenden Ansprüche, mit dem Schritt:
- Erwärmen des Objekts (8;15) auf eine zweite Temperatur, die die Glasübergangstemperatur nicht überschreitet, beim Pressen des Negativmusters (6) der ersten Oberfläche (4) in die zweite Oberfläche.

10. Verfahren nach Anspruch 9 in Verbindung mit Anspruch 3, wobei das Material der zweiten Polymerfolie (8) eine Glasübergangstemperatur hat, die niedriger ist als die zweite Temperatur.

11. Verfahren nach Anspruch 10, wobei die zweite Polymerfolie (8) ein Polymer aufweist, der durch Bestrahlung vernetzbar ist, ferner mit dem Schritt:
- Bestrahlen der zweiten Polymerfolie (8) beim Pressen des Negativmusters (6) der ersten Oberfläche (4) in die zweite Polymerfolie (8), um das Polymer zu vernetzen.

12. Verfahren nach einem der vorstehenden Ansprüche, wobei die erste Polymerfolie (3) eine Dicke von 50µm bis 1mm hat.

## Revendications

1. Procédé de transfert d'un motif depuis un modèle sur un objet dans un procédé d'impression, comprenant les étapes suivantes :
fourniture d'une première feuille de polymère (3) comprenant un polymère qui est réticulable par exposition à un rayonnement ;
chauffage de la première feuille de polymère (3) à une première température supérieure à la température de transition vitreuse du matériau de la première feuille de polymère (3) ;
compression d'un motif d'une surface de modèle (2) sur une première surface (4) de la première feuille de polymère (3) pour imprimer l'inverse du motif sur la première surface (4) ;
exposition de la première feuille de polymère (3) à un rayonnement suite à la compression de la surface de modèle (2) sur la première surface (4), pour réticuler ledit polymère ;
détachement de la première feuille de polymère (3) du modèle (1) ; et
compression du motif inverse (6) de la première surface (4) sur une seconde surface d'un objet (8 ; 15), pour imprimer une réplique du motif de la surface de modèle (2) sur la seconde surface.

2. Procédé selon la revendication 1, dans lequel l'objet est un substrat (16) et la seconde surface est une couche de matériau de réserve (17) portée par le substrat (16).

3. Procédé selon la revendication 1, dans lequel l'objet est une seconde feuille de polymère (8).

4. Procédé selon la revendication 3, comprenant les étapes suivantes :
détachement de la seconde feuille de polymère (8) de la première feuille de polymère (3) ; et
compression de la réplique du motif de la surface de modèle (2) de la seconde surface sur une troisième surface (18) d'une couche de matériau de réserve (17) portée par un substrat (16), pour imprimer l'inverse du motif de la surface de modèle (2) sur la troisième surface (18).

5. Procédé selon la revendication 3, dans lequel la seconde feuille de polymère (8) est faite d'un polymère thermoplastique ou d'un matériau de copolymère.

6. Procédé selon la revendication 1, dans lequel la première feuille de polymère (3) est transparente à un rayonnement UV dans au moins une plage entre 300 et 400 nm, et la seconde surface est la surface d'un matériau plastique photosensible qui peut être durci suite à une exposition à au moins ladite plage, comprenant l'étape suivante :
exposition dudit matériau plastique photosensible de l'objet à un rayonnement UV, à travers la première feuille de polymère (3), suite à la compression du motif inverse (6) de la première surface (4) sur la seconde surface, pour durcir le matériau plastique photosensible.

7. Procédé selon la revendication 4, dans lequel la seconde feuille de polymère (8) est transparente à un rayonnement UV dans au moins une plage entre 300nm et 400 nm, et la troisième surface (18) est la surface d'un matériau photosensible qui peut être durci suite à une exposition à au moins ladite plage, comprenant l'étape suivante :
exposition dudit matériau photosensible à un rayonnement UV, à travers la seconde feuille de polymère (8), suite à la compression de la réplique (9) du motif de la surface du modèle (2) de la seconde surface sur la troisième surface (18), pour durcir le matériau photosensible.

8. Procédé selon l'une quelconque des revendications précédentes, dans lequel le modèle (1) est fait d'un métal, de quartz ou de silicium.

9. Procédé selon l'une quelconque des revendications précédentes, comprenant l'étape suivante :
chauffage de l'objet (8 ; 15), suite à la compression du motif inverse (6) de la première surface (4) sur la seconde surface, à une seconde température qui n'est pas supérieure à ladite température de transition vitreuse.

10. Procédé selon la revendication 9 en conjonction avec la revendication 3, dans lequel le matériau de la seconde feuille de polymère (8) a une température de transition vitreuse qui est inférieure à ladite seconde température.

11. Procédé selon la revendication 10, dans lequel la seconde feuille de polymère (8) comprend un polymère qui est réticulable par exposition à un rayonnement, comprenant en outre l'étape suivante :
exposition de la seconde feuille de polymère (8) à un rayonnement, suite à la compression du motif inverse (6) de la première surface (4) sur la seconde feuille de polymère (8), pour réticuler ledit polymère.

12. Procédé selon l'une quelconque des revendications précédentes, dans lequel la première feuille de polymère (3) a une épaisseur de 50 µm à 1 mm.
